# EUROPEAN PATENT APPLICATION

(11) **EP 1 382 446 A1**
(43) Date of publication of application: **21.01.2004**
(21) Application number: 03015635.0
(22) Date of filing: 16.07.2003
(51) Int. Cl.: B41C 1/05, B41M 5/24, G03F 1/00

(54) **Laminate for IR ablation**

(30) Priority: 16.07.2002 JP 2002207319; 12.06.2003 JP 2003167899; 24.06.2003 JP 2003179734
(71) Applicant: Toyo Boseki Kabushiki Kaisha, Osaka-shi, Osaka 530-8230 (JP)
(72) Inventor: Wada, Toru, Toyo Boseki K.K., Ohtsu-shi, Shiga 520-0292 (JP); Motoi, Keiichi, Toyo Boseki K.K., Ohtsu-shi, Shiga 520-0292 (JP); Syoki, Koji, Toyo Boseki K.K., Ohtsu-shi, Shiga 520-0292 (JP); Tanaka, Machiko, Toyo Boseki K.K., Head Office, Osaka-shi, Osaka 530-8230 (JP)
(74) Representative: VOSSIUS & PARTNER

(57) **Abstract**

The present invention provides a laminate for IR ablation comprising at least a substrate and an IR ablation layer, wherein the aforementioned IR ablation layer comprises an IR absorbent metal layer and a method for forming a mask on a photosensitive resin layer, which comprises a step of IR ablation of a laminate comprising at least a substrate and an IR ablation layer which is laminated on said photosensitive resin layer, wherein the IR ablation layer comprises an IR absorbent metal layer.

## Description

The present invention relates to a laminate for IR ablation used for producing a relief printing plate and a relief plate by computer plate making techniques.

In the field of relief printing, flexo and the like, computer plate making techniques (computer to plate (CTP) technique), also known as digital image formation techniques, are becoming extremely general nowadays. In the CTP techniques, a photographic mask (also called a photomask or negative film) conventionally used for covering an area unwanted to be polymerized on a photosensitive printing plate has been replaced by a mask formed and integrated within the printing plate. There are two techniques in the market as a method to obtain such integrated mask. One is a method to print a mask on a photosensitive plate by an inkjet printer, and the other is a method to form a mask by forming, on a photosensitive layer, a layer substantially non-transparent to ultraviolet rays (UV) (i.e., substantially blocks ultraviolet rays), and ablatable by irradiation of IR laser (this layer is generally referred to as an "IR ablation layer" etc. and is referred to as an "IR ablation layer" in the present specification), and forming an image on this layer with an IR laser. Using these techniques, an image (mask) is directly formed on a plate, and ultraviolet rays are irradiated through this image (mask) in the next step to afford plate making.

The CTP technique is convenient in that it does not require a negative film and can afford a resolution far higher than that by a conventional technique using a negative film.

In a photosensitive plate having the above-mentioned IR ablation layer, the IR ablation layer is generally made from a composition containing a polymer binder containing carbon black in a large amount. In general, a cover film is formed on an IR ablation layer for protection of the IR ablation layer during preservation of the plate and handling thereof, and this cover film is removed before irradiation of IR laser or after irradiation of IR laser (generally after main exposure and before development). However, printing cost becomes higher because carbon black in the IR ablation layer transfers to and stain a developer during developing with the developer after a main exposure (irradiation of ultraviolet rays) after IR ablation, which necessitates exchange of the developer each time a plate is made.

In addition, blocking occurs on the opposite side from the IR ablation layer of the cover film (also referred to as a substrate in the present invention) during processing for forming an IR ablation layer, thus degrading productivity and producing an adverse influence on the quality after processing.

Moreover, a part of the IR ablation layer is also removed when removing a cover film (substrate) before irradiation of IR laser or after the irradiation of IR laser (generally, after main exposure and before development), thus defectively failing to provide high grade printing images.

Thus, there is a demand for a laminate for IR ablation, which solves the above-mentioned conventional problems, affords high grade printing images, reduces staining of developer, and which is applicable to various photosensitive resin layers.

In view of the above-mentioned situation, it is therefore an object of the present invention to provide a laminate, which affords high grade printing images, reduces staining of developer, and which is applicable to various photosensitive resin layers, as compared to conventional laminates.

Accordingly, the present invention provides the following.
(1) A laminate for IR ablation comprising at least a substrate and an IR ablation layer, wherein the aforementioned IR ablation layer comprises an IR absorbent metal layer.
(2) The laminate for IR ablation of the above-mentioned (1), wherein the IR absorbent metal layer is a metal deposition layer.
(3) The laminate for IR ablation of the above-mentioned (1), which further comprises an anti-blocking layer on the opposite side of the IR ablation layer of the substrate.
(4) The laminate for IR ablation of the above-mentioned (1), which further comprises a release layer between the substrate and the IR ablation layer.
(5) The laminate for IR ablation of the above-mentioned (3), wherein the anti-blocking layer comprises a thermosetting resin.
(6) The laminate for IR ablation of the above-mentioned (3), wherein the anti-blocking layer comprises an alkyd resin.
(7) The laminate for IR ablation of the above-mentioned (4), wherein the release layer comprises a thermosetting resin.
(8) The laminate for IR ablation of the above-mentioned (4), wherein the release layer comprises an alkyd resin.
(9) The laminate for IR ablation of the above-mentioned (1), which further comprises an IR non-sensitive polymer resin layer between the substrate and the IR absorbent metal layer.
(10) The laminate for IR ablation of the above-mentioned (4), which further comprises an IR non-sensitive polymer resin layer between the release layer and the IR absorbent metal layer.
(11) A method for forming a mask on a photosensitive resin layer, which comprises a step of IR ablation of a laminate comprising at least a substrate and an IR ablation layer which is laminated on said photosensitive resin layer, wherein the IR ablation layer comprises an IR absorbent metal layer.
(12) The method of the above-mentioned (11), wherein the IR absorbent metal layer is a metal deposition layer.
(13) The method of the above-mentioned (11), wherein the laminate comprises an anti-blocking layer on the opposite side of an IR ablation layer of the substrate.
(14) The method of the above-mentioned (11), wherein the laminate comprises a release layer between the substrate and the IR ablation layer.
(15) The method of the above-mentioned (13), wherein the anti-blocking layer comprises a thermosetting resin.
(16) The method of the above-mentioned (13), wherein the anti-blocking layer comprises an alkyd resin.
(17) The method of the above-mentioned (14), wherein the release layer comprises a thermosetting resin.
(18) The method of the above-mentioned (14), wherein the release layer comprises an alkyd resin.
(19) The method of the above-mentioned (11), wherein the laminate comprises an IR non-sensitive polymer resin layer between the substrate and the IR absorbent metal layer.
(20) The method of the above-mentioned (14), wherein the laminate comprises an IR non-sensitive polymer resin layer between the release layer and the IR absorbent metal layer.

Fig. 1 is a schematic sectional view showing a first embodiment of the laminate for IR ablation of the present invention.

Fig. 2 is a schematic sectional view showing a second embodiment of the laminate for IR ablation of the present invention.

Fig. 3 is a schematic sectional view showing a third embodiment of the laminate for IR ablation of the present invention.

Fig. 4 is a schematic sectional view showing a fourth embodiment of the laminate for IR ablation of the present invention.

Fig. 5 is a schematic sectional view wherein the laminate for IR ablation of the present invention shown in Fig. 1 is applied to a photosensitive resin plate.

Fig. 6 is a schematic sectional view wherein the laminate for IR ablation of the present invention shown in Fig. 2 is applied to a photosensitive resin plate.

Fig. 7 is a schematic sectional view wherein the laminate for IR ablation of the present invention shown in Fig. 3 is applied to a photosensitive resin plate.

Fig. 8 is a schematic sectional view wherein the laminate for IR ablation of the present invention shown in Fig. 4 is applied to a photosensitive resin plate.

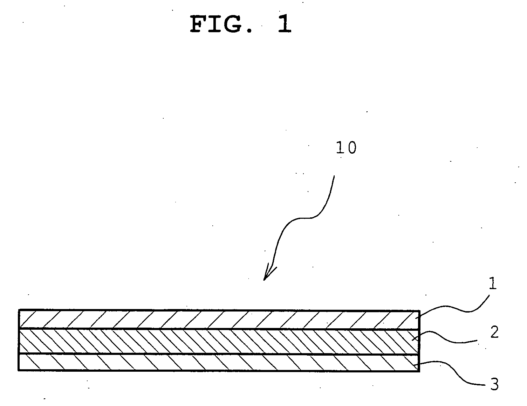

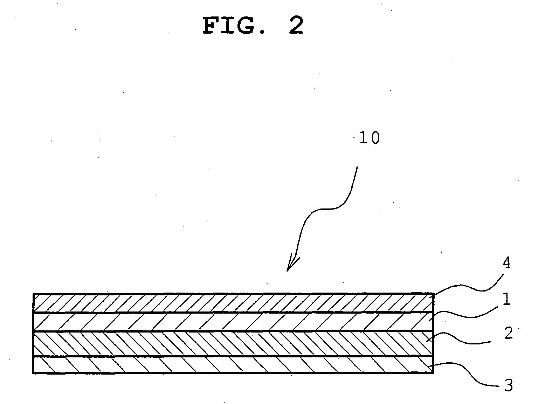

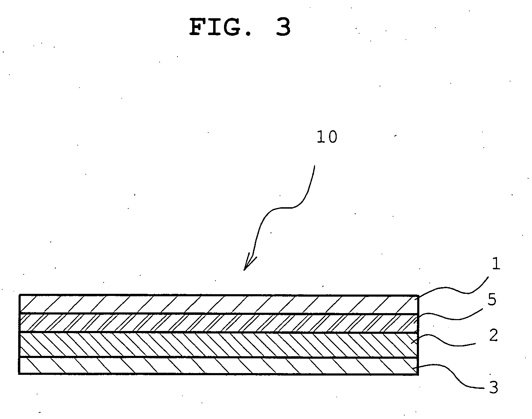

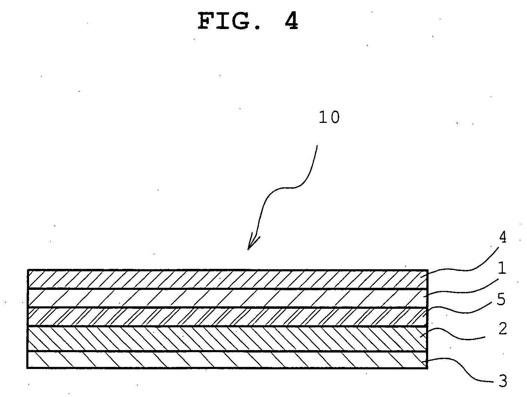

Fig. 1 is a schematic sectional view showing one embodiment of the laminate 10 for IR ablation of the present invention, comprising a substrate 1, an IR non-sensitive polymer resin layer 2 and an IR absorbent metal layer 3, which is an IR ablation layer, Fig. 2 is a schematic sectional view showing one embodiment of the laminate 10 for IR ablation of the present invention, further comprising an anti-blocking layer 4, Fig. 3 is a schematic sectional view showing one embodiment of the laminate 10 for IR ablation of the present invention, comprising a release layer 5, and Fig. 4 is a schematic sectional view showing one embodiment of the laminate 10 for IR ablation of the present invention, concurrently comprising an anti-blocking layer 4 and a release layer 5.

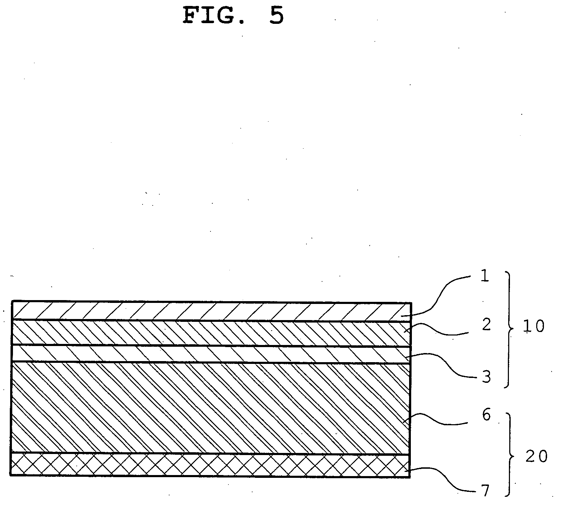

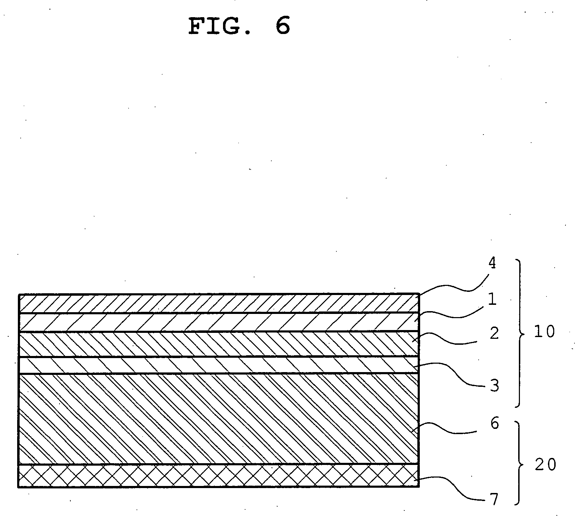

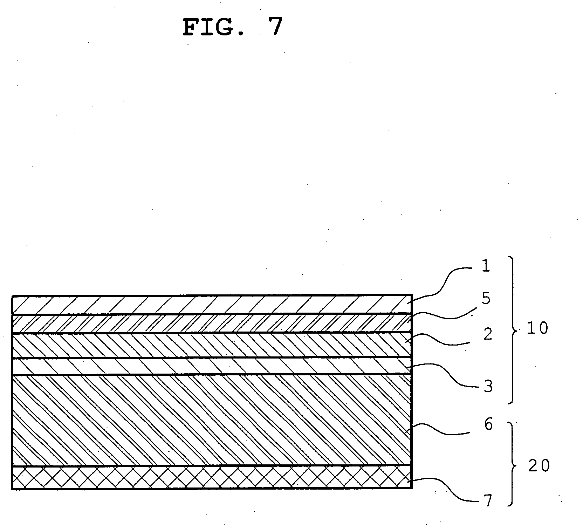

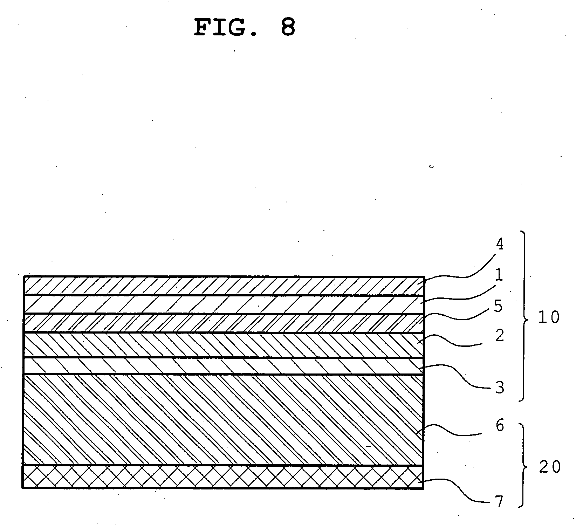

As an example of application of the laminate for IR ablation of the present invention to a photosensitive resin plate 20 comprising a photosensitive resin layer 6 and a support 7, Fig. 5 is a schematic sectional view showing one embodiment, wherein the laminate for IR ablation 10 shown in Fig. 1 is laminated as it is on the photosensitive resin layer 6, Fig. 6 is a schematic sectional view showing one embodiment, wherein the laminate for IR ablation 10 shown in Fig. 2 is laminated as it is on the photosensitive resin layer 6, Fig. 7 is a schematic sectional view showing one embodiment, wherein the laminate for IR ablation 10 shown in Fig. 3 is laminated as it is on the photosensitive resin layer 6, and Fig. 8 is a schematic sectional view showing one embodiment, wherein the laminate for IR ablation 10 shown in Fig. 4 is laminated as it is.

As mentioned below, the substrate 1 of the present invention becomes a cover film when applied to a photosensitive resin plate, wherein the cover film is formed for the protection of the IR ablation layer during storage and handling of the plate, and removed (peeled off) before or after the IR irradiation.

In the present invention, the substrate 1 preferably consists of materials of polyamide; polyvinyl alcohol; copolymer of ethylene and vinyl acetate; amphoteric interpolymer; cellulose polymers such as hydroxyalkylcellulose and cellulose acetate; polybutyral; cyclic rubber and the like. As used herein, the amphoteric interpolymer is described in US Patent No. 4,293,635. These materials may be used alone or in combination of two or more kinds thereof. In addition, self-oxidative compounds such as nitrocellulose and nitroglycerine; non-self oxidative polymers such as alkylcellulose (e.g., ethylcellulose), polyacrylic acid and alkali metal salt thereof; polyacetal; polyimide; polycarbonate; polyester; polyalkylene such as polyethylene and polybutylene; polyphenylene ether; polyethylene oxide; polylactone; combinations thereof and the like can be also used.

Besides the aforementioned, the material of the substrate (cover film) is preferably polyethylene, polypropylene, polyethylene terephthalate, polyethylene-2,6-naphthalate, nylon 6, nylon 4, nylon 66, nylon 12, polyvinyl chloride, polyvinylidene chloride, polyvinyl alcohol, full aromatic polyamide, polyamideimide, polyimide, polyetherimide, polysulfone, polyphenylene sulfide, polyphenylene oxide, and the like. Any of these may be used alone or two or more kinds thereof may be used in combination. In addition, a small amount of other organic polymer may be copolymerized or blended. The thickness of the substrate is preferably 10 - 300 µm, particularly preferably 10 - 200 µm.

In the present invention, the IR absorbent layer includes an IR absorbent metal layer, and by the "IR absorbent metal" is meant a metal, an alloy or a metal-containing compound capable of being ablated upon absorption of IR, wherein the alloy here includes not only a melt product of two or more kinds of metal elements but a melt product containing two or more kinds of metal elements as well as an element other than the metal elements. The "IR absorbent metal" may be one kind of material or a combination of two or more kinds of materials.

Preferable examples of the above-mentioned metal include Al, Zn and Cu. Preferable examples of the above-mentioned alloy include an alloy of two or more kinds of metals selected from Al, Ca, Sc, Tl, V, Sb, Cr, Mn, Fe, Co, Ni, Cu, Zn, Y, Zr, Nb, Mo, Ag, In, Sn, Ta, W, Au, Bi and Pb, and an alloy containing, along with the two or more kinds of metals, a non-metal element (carbon, silicon etc.) and/or a rare-earth element (Nd, Sm, Gd, Tb etc.). As the metal-containing compound, various compounds of metal oxide, metal nitride and the like can be used, as long as they absorb IR and are ablated. Of those, dark inorganic pigments such as copper chromite, chromic oxide, cobalt aluminate-chrome and the like are preferable.

For prevention of breakage and flaws (film strength) of the IR ablation layer, the IR absorbent metal is preferably a metal or an alloy, particularly preferably Al, Zn, Cu and a Bi-In-Cu alloy, particularly preferably Al. In a preferable embodiment of the present invention, the IR absorbent metal layer is a metal deposition layer.

The anti-blocking layer used as a preferable embodiment in the present invention is formed on the opposite side of the IR ablation layer of the substrate (also referred to as a cover film in the present invention). An anti-blocking layer is formed by processing a roll substrate, and an IR non-sensitive layer and an IR ablation layer are formed in the next step. During the process, the presence of the aforementioned anti-blocking layer prevents close adhesion, in a roll state, of the IR non-sensitive layer and the cover film and improves the processability of the IR ablation layer since then.

The release layer to be used for a preferable embodiment in the present invention is characteristically formed between the substrate (cover film) and the IR ablation layer, wherein the release layer is preferably formed in direct contact with the substrate. The release layer is formed by processing a roll substrate, and an IR non-sensitive layer and an IR ablation layer are formed in the next step.

In the present invention, it is more preferable to form both the aforementioned anti-blocking layer and the release layer.

As a material constituting the anti-blocking layer and a release layer in the present invention, a thermosetting resin is preferably used. The thermosetting resin may be an alkyd resin, a melamine resin, a urea resin, a benzoguanamine resin, a glycol lauryl resin, an epoxy resin and the like or a mixture of these. Preferably, an alkyd resin modified by saturated fatty acid is used and more preferably, a mixture of an alkyd resin modified by saturated fatty acid and a melamine resin is used. As the saturated fatty acid to modify the alkyd resin, myristic acid, palmitic acid, stearic acid, behenic acid and the like are used. The mixing ratio of the alkyd resin modified by saturated fatty acid and the melamine resin is preferably 100/0 - 5/95 parts by weight, more preferably 100/0 - 15/85 parts by weight. When a melamine resin alone is used, adhesion to an IR absorbent metal layer that comes into contact upon winding in a roll becomes great, causing rise of the IR absorbent metal layer, which unpreferably prevents provision of a fine laminate.

The release layer used in the present invention may be one containing a curable silicone resin, or one containing a curable silicone resin as a main component, or a modified silicone type produced by graft polymerization with an organic resin such as urethane resin, epoxy resin, alkyd resin and the like. As the curable silicone resin, any curing reaction type such as addition type, condensation type, UV curable type, electron beam curable type, non-solvent type and the like can be used. Specific examples thereof include KS-774, KS-775, KS-778, KS-779H, KS-856, X-62-2422 and X-62-2461 manufactured by Shin-Etsu Chemical Co., Ltd., DKQ3-202, DKQ3-203, DKQ3-204, DKQ3-205 and DKQ3-210 manufactured by Dow Corning Asia, Ltd., YSR-3022, TPR-6700, TPR-6720 and, TPR-6721 manufactured by GE Toshiba Silicones Co., Ltd., SD7223, SD7226, SD7229 and LTC750A manufactured by Dow Corning Toray Silicone Co., Ltd. and the like. A release controlling agent and the like may be further added concurrently to control release property of the release layer.

In addition, a lubricant, an antistatic agent and the like may be added to the anti-blocking layer or release layer, where necessary.

For forming an anti-blocking layer or release layer on a substrate (cover film) in the present invention, any method can be used such as coating methods and the like. For example, a method comprising applying a coating solution using a coating tool such as a reverse roll coater, a gravure coater, a rod coater, an air doctor coater (Yuji Harasaki, Coating Method, Maki Shoten (1979)) or other coater, within the production step of the cover film but other than the production step of the cover film, and the like can be employed. For coating within the production step of the cover film, a method comprising applying a coating solution to a typical non-stretched thermoplastic resin film and biaxially drawing the film sequentially or simultaneously, a method comprising applying a coating solution to a uniaxially stretched thermoplastic resin film and drawing the film in the direction perpendicular to the direction of the preceding uniaxial stretching, or applying a coating solution to a biaxially stretched thermoplastic resin film and further drawing in the transverse and/or longitudinal direction and the like can be employed.

The thickness of the aforementioned anti-blocking layer or release layer is preferably 0.01 - 10 µm, more preferably 0.05 - 5 µm. When the thickness of this layer is less than 0.01 µm, a uniform layer is difficult to obtain, which in turn prevents an anti-blocking effect or release effect. In contrast, when the thickness is greater than 10 µm, the thermosetting resin is often cured insufficiently, which also unpreferably prevents an anti-blocking effect or release effect.

In a preferable embodiment of the present invention, an IR non-sensitive polymer resin layer may be formed between a substrate and an IR absorbent metal layer, or a release layer and an IR absorbent metal layer. Examples of the material constituting the IR non-sensitive polymer resin layer include polyamide, polyethylene, polypropylene, polyvinyl alcohol, polyacrylic acid, polyethylene oxide, amphoteric interpolymer, alkylcellulose, cellulose polymer (particularly hydroxypropyl cellulose, hydroxyethyl cellulose, nitrocellulose), copolymer of ethylene and vinyl acetate, cellulose acetate butyrate, polybutyral, cyclic rubber and the like. They may be used alone or in combination of two or more kinds thereof. The amphoteric interpolymer is described in US Patent No. 4,293,635.

Of the materials exemplified above, polyvinyl alcohol, modified polyvinyl alcohol, polyacrylic acid, polyethylene oxide are used in the present invention in view of the developability in water or an aqueous medium, occurrence of wrinkles and the like. Of these, polyvinyl alcohol or modified polyvinyl alcohol having a degree of polymerization of 500 - 4000, preferably 1000 - 3000, and a degree of saponification of not less than 70%, preferably 80 - 99%, more preferably 80 - 90%, is used. As used herein, by the modified polyvinyl alcohol means one having carboxyl group, carbonyl group, polyoxyalkylene group, acetoacetyl group, sulfone group or silanol group introduced into a terminal or a main chain by secondary reaction with a compound reactive with hydroxyl group of polyvinyl alcohol (e.g., a compound having carboxyl group, double bond, aromatic ring and the like) or saponification of a copolymer of vinyl acetate and a different vinyl monomer.

The IR non-sensitive polymer resin layer of the present invention has a thickness of 0.01 - 200 µm, preferably 0.1 - 100 µm, particularly preferably 0.1 - 50 µm. When the thickness exceeds 200 µm, it may not be easily set on a drum for IR ablation, or the relief obtained by main exposure and development may show lower resolution, which is not preferable. The IR non-sensitive polymer resin layer may contain a compound that absorbs ultraviolet rays, such as UV absorbent, metal and the like for the prevention of fogging phenomenon during main exposure.

By forming the above-mentioned IR non-sensitive polymer resin layer between a substrate and an IR absorbent metal layer, or a release layer and an IR absorbent metal layer, damage of the IR absorbent metal layer upon peeling off of the substrate (cover film) can be prevented and the metal layer can be transferred directly onto the photosensitive resin layer without damage. Moreover, the IR non-sensitive polymer resin layer plays a role of a protection layer of the transferred IR absorbent metal layer.

In the present invention, the IR ablation layer does not substantially allow transmission of ultraviolet rays (actinic radiation). That is, an optical density for actinic radiation exceeds 2.0, preferably over 2.5. When the optical density is less than 2.0, the masked part is cured by UV leak during main exposure, converting originally a non-image part to an image area, which unpreferably results in, what is called, a fogging phenomenon.

To meet the aforementioned optical density, the IR absorbent metal layer 3 preferably has a thickness of 70 - 20000 Å, more preferably 100 - 8000 Å, particularly preferably 100 - 5000 Å. When the thickness is less than 70 Å, masking function after IR ablation becomes unpreferably low, and when it exceeds 20000 Å, IR for image formation unpreferably fails to cause ablation.

In contrast, when the IR ablation layer consists of the IR absorbent metal layer 3 and other IR absorbent material layer, the IR absorbent metal layer 3 preferably has a thickness of 50 - 15000 Å, more preferably 70 - 8000 Å, particularly preferably 100 - 5000 Å. When the thickness is less than 50 Å, masking function after IR ablation becomes unpreferably low, and when it exceeds 15000 Å, IR for image formation unpreferably fails to cause ablation.

When the laminate for IR ablation of the present invention is, applied to a photosensitive resin plate comprising at least a photosensitive resin layer and a support, the laminates for IR ablation shown in Figs. 1 - 4 may be directly laminated on a photosensitive resin layer 6.

The aforementioned photosensitive resin layer 6 is a layer made from a composition at least containing a known soluble synthetic polymer compound containing an elastomer binder and the like, a photopolymerizable unsaturated compound (in the following, to be also referred to as a crosslinking agent) and a photoinitiator. In addition, it may contain an additive, such as plasticizer, thermal polymerization inhibitor, dye, pigment, UV absorbent, flavoring and antioxidant.

As the aforementioned soluble synthetic polymer compound, known soluble synthetic polymer compounds can be used. For example, polyetheramide (JP-A-55-79437 and the like), polyether esteramide (JP-A-58-113537 and the like), tertiary nitrogen-containing polyamide (JP-A-50-76055 and the like), ammonium salt type tertiary nitrogen atom-containing polyamide (JP-A-53-36555 and the like), addition polymer of amide compound having one or more amide bonds and organic diisocyanate compound (JP-A-58-140737 and the like), addition polymer of diamine without amide bond and organic diisocyanate compound (JP-A-4-97154 and the like) and the like are mentioned. Of these, tertiary nitrogen atom-containing polyamide and ammonium salt type tertiary nitrogen atom-containing polyamide are preferable.

The elastomer binder may be a single polymer or a polymer mixture. It may be a hydrophobic polymer, a hydrophilic polymer or a mixture of a hydrophobic polymer and a hydrophilic polymer. Preferable examples of the hydrophobic polymer include butadiene rubber, isoprene rubber, 1,2-polybutadiene, styrene-butadiene rubber, chloroprene rubber, nitrile-butadiene rubber, styrene-butadiene-styrene block copolymer, styrene-isoprene-styrene block copolymer, butyl rubber, ethylenepropylene rubber, chlorosulfonated polyethylene, butadiene-(meth)acrylic acid ester copolymer, acrylonitrile-(meth)acrylic acid ester copolymer, epichlorohydrin rubber, chlorinated polyethylene, silicone rubber and urethane rubber, which may be used alone or in combination of two or more kinds thereof. Preferable examples of the hydrophilic polymer include one having a hydrophilic group, such as -COOH, -COOM (M is monovalent, divalent or trivalent metal ion or substituted or non-substituted ammonium ion), -OH, -NH₂, -SO₃H, phosphoric acid ester group and the like, which is specifically polymers of (meth)acrylic acid or a salt thereof, copolymers of (meth)acrylic acid or a salt thereof and alkyl (meth)acrylate, copolymers of (meth)acrylic acid or a salt thereof and styrene, copolymers of (meth)acrylic acid or a salt thereof and vinyl acetate, copolymers of (meth)acrylic acid or a salt thereof and acrylonitrile, polyvinyl alcohol, carboxymethyl cellulose, polyacrylamide, hydroxyethyl cellulose, polyethylene oxide, polyethyleneimine, polyurethane having -COOM group, polyureaurethane having -COOM group, polyamic acid having -COOM group and salts thereof or derivatives thereof, which may be used alone or in combination of two or more kinds thereof.

The photopolymerizable unsaturated compound preferably used above is exemplified by ring opening addition reaction product of polyglycidyl ether of polyhydric alcohol with methacrylic acid and acrylic acid. Examples of the aforementioned polyhydric alcohol include dipentaerythritol, pentaerythritol, trimethylolpropane, glycerine, ethylene glycol, diethylene glycol, triethylene glycol, ethylene oxide adduct of phthalic acid and the like. Of these, trimethylolpropane is preferable.

When the soluble synthetic polymer compound is an elastomer binder, preferable photopolymerizable unsaturated compound is a polymerizable ethylenically mono- or polyunsaturated organic compound that can be used for the production of a photosensitive (polymerizable) printing plate and is compatible with elastomer binders. Examples of the compound include styrene, vinyltoluene, t-butylstyrene, α-methylstyrene, acrylonitrile, (meth) acrylic acid, methyl (meth) acrylate, ethyl(meth)acrylate, n-propyl (meth)acrylate, iso-propyl (meth)acrylate, n-butyl(meth)acrylate, iso-butyl(meth)acrylate, sec-butyl(meth)acrylate, t-butyl(meth)acrylate, 2-ethylhexyl(meth)acrylate, n-decyl (meth)acrylate, lauryl(meth)acrylate, n-tridecyl (meth)acrylate, stearyl(meth)acrylate, ethylene glycol mono(meth)acrylate, propylene glycol mono (meth) acrylate, diethylene glycol mono(meth)acrylate, dipropylene glycol mono(meth)acrylate, polyethylene glycol mono(meth)acrylate, polypropylene glycol mono(meth)acrylate, polyethylene glycol monomethylether mono(meth)acrylate, polypropylene glycol monomethylether mono (meth) acrylate, polyethylene glycol monoethylether mono (meth) acrylate, polypropylene glycol monoethylether mono (meth) acrylate, n-butoxyethyl(meth)acrylate, phenoxyethyl(meth)acrylate, 2-phenoxypropyl(meth)acrylate, cyclohexyl(meth) acrylate, tetrahydrofurfuryl(meth)acrylate, glycidyl(meth)acrylate, allyl (meth) acrylate, benzyl(meth)acrylate, tribromophenyl(meth)acrylate, 2,3-dichloropropyl (meth) acrylate1 3-chloro-2-hydroxypropyl(meth)acrylate, N,N-diethylaminoethyl(meth)acrylate, N,N-dimethylaminoethyl(meth)acrylate, N-t-butylaminoethyl(meth)acrylate, acrylamide, N,N-dimethylacrylamide, N,N-diethylacrylamide, ethylene glycol di (meth) acrylate, diethylene glycol di (meth) acrylate, polyethylene glycol di(meth)acrylate, propylene glycol di (Meth) acrylate, dipropylene glycol di (meth) acrylate, polypropylene glycol di (meth) acrylate, 1,3-butyleneglycol (meth) acrylate, 1,4-butanediol (meth)acrylate, neopentylglycol di (meth) acrylate, 1,6-hexanediol di (meth) acrylate, 1,9-nonanediol di (meth) acrylate, 1,10-decanediol di(meth)acrylate, 1,12-dodecanediol di (meth) acrylate, 1,14-tetradecanediol di (meth) acrylate, pentaerythritol di(meth)acrylate, pentaerythritol tri (meth) acrylate, pentaerythritol tetra (meth) acrylate, glycelol di (meth) acrylate, glycelol allyloxy di(meth)acrylate, trimethylolethane di (meth) acrylate, trimethylolethane tri (meth) acrylate, trimethylolpropane di(meth)acrylate, trimethylolpropane tri(meth)acrylate, dicyclopentyldimethylene di(meth)acrylate, dicyclopentadecane di (meth) acrylate, tricyclodecanediyldimethyl di(meth)acrylate, triallylcyanurate, triallylisocyanurate, triallyltrimellitate, diallylphthalate, divinylbenzene, polyurethane (meth)acrylate, polyester (meth) acrylate, oligobutadiene (meth) acrylate, oligoisoprene (meth) acrylate, oligopropylene (meth) acrylate and the like, which may be used alone or in combination of two or more kinds thereof.

Preferable examples of the photoinitiator include benzophenones, benzoins, acetophenones, benzils, benzoin alkylethers, benzylalkylketals, anthraquinones, thioxanthones and the like, which are specifically benzophenone, chlorobenzophenone, benzoin, acetophenone, benzil, benzoin methylether, benzoin ethylether, benzoin isopropyl ether, benzoin isobutylether, benzyldimethylketal, benzyldiethylketal, benzyldiisopropylketal, anthraquinone, 2-ethylanthraquinone, 2-methylanthraquinone, 2-allylanthraquinone, 2-chloroanthraquinone, thioxanthone, 2-chlorothioxanthone and the like, which may be used alone or in combination of two or more kinds thereof.

The photosensitive resin layer can be prepared into a layer soluble or dispersible in a water-soluble developer, a semiwater-soluble developer and an organic solvent developer by appropriately changing the materials of each component. It is preferably made to be developable in water or an aqueous medium. When preparing a photosensitive resin layer that can be developed in water or an aqueous medium, it preferably corresponds to the photosensitive resin layer specifically described in EP-A767407, JP-A-60-211451, JP-A-2-175702, JP-A-4-3162, JP-A-2-305805, JP-A-3-228060, JP-A-10-339951 and the like.

The support in the present invention is preferably a material having flexibility and superior in dimensional stability, and examples thereof include polyethylene terephthalate film, polyethylene naphthalate film, polybutylene terephthalate film, polycarbonate film and the like. The support used here desirably has a thickness of 50 - 350 µm, preferably 100 - 250 µm, in view of mechanical property and shape stability of a plate and handling property during printing plate making and the like. Where necessary, a known adhesive conventionally used for this kind of purposes may be applied to improve adhesion between a support and a photosensitive resin layer.

The method for producing the laminate for IR ablation of the present invention is not particularly limited. For example, the laminate can be obtained by forming an IR non-sensitive polymer resin layer on a substrate (cover film), by coating, spray coating and the like, and then successively forming an IR absorbent metal layer by vacuum deposition, sputtering and the like.

The method for preparing the aforementioned photosensitive plate is not particularly limited but generally, a photosensitive resin layer is formed on a support by applying, spray coating and the like to give one of the two laminates, or a protective film is peeled off from a commercially available photosensitive printing plate to give one laminate. Separately, the aforementioned laminate for IR abrasion is formed, and these two laminates are laminated using a heat press machinery and the like. The laminating conditions are temperature: room temperature to 150°C, preferably 50 - 120°C, pressure: 20 - 200 kg-weight/cm², preferably 50 - 150 kg-weight/cm².

A printing plate can be prepared from the aforementioned photosensitive plate as in the following.

After a cover film is or is not peeled off, an ablation layer is exposed to IR laser image for IR ablation, whereby a mask is formed on a photosensitive resin layer. Examples of suitable IR laser include ND/YAG laser (1064 nm) and diode laser (e.g., 830 nm). A laser system suitable for a computer plate making technique is commercially available, and exemplified by Cyrel Digital Imager Spark (manufactured by BARCO), diode laser system OmniSetter (registered trademark) (Fa. Misomex; laser wavelength: 830 nm; drum axis: 1800 mm) and ND/YAG laser system Digilas (registered trademark; Fa. Schepers). These include a rotary cylindrical drum to support a photosensitive plate, an IR laser irradiation apparatus and a layout computer. The image information is directly transmitted from the layout computer to the laser apparatus.

After writing the mask on the IR ablation layer as mentioned above, the photosensitive plate is entirely exposed to actinic radiation through the mask. This is advantageously done directly on the laser cylinder. Alternatively, the plate may be removed from the laser apparatus and exposed to actinic radiation on a conventional flat irradiation unit. During the irradiation step, the photosensitive resin layer polymerizes in the area exposed in the above-mentioned mask forming step (ablation step) and otherwise in the IR ablation layer area which is covered with the IR ablation layer non-transparent to irradiation light. The actinic radiation may be applied in a conventional vacuum frame without oxygen, but it is advantageously applied in the presence of atmospheric oxygen.

After exposure to actinic radiation as mentioned above, the plate is subjected to development. The development step can be performed using a conventional development unit, and depending on the properties of the plate, water, an organic solvent or a mixture thereof can be used. During the development, non-polymerized area of the photosensitive resin layer and the remaining part of the IR ablation layer are removed. It is possible to first remove the IR ablation layer with one kind of a solvent or a solvent mixture and develop the photosensitive resin layer with a different developer. After the development step, the obtained printing plate is dried. The drying conditions of the plate are, for example, 45 - 80°C for 5 min - 4 hr. After drying, some post-treatments may be performed. For example, to make a printing plate non-adhesive, irradiation with a germicidal lamp or a treatment with Br₂ may be applied.

### Examples

In the following, the present invention is explained in detail by referring to Examples and Comparative Examples. The present invention is not limited by these examples.

### Example 1

### Preparation of laminate for IR ablation

An aqueous solution of polyvinyl alcohol (GOHSENOL AH-26 manufactured by NIPPON SYNTHETIC CHEMICAL INDUSTRY CO., LTD.)/propylene glycol (manufactured by ASAHI DENKA Co., Ltd.)/surfactant (EPAN 740 manufactured by Dai-ichi Kogyo Seiyaku Co., Ltd.)/pure water=8.75 g/8.75 g/0.01 g/332.5 g was applied to a PET film (substrate (cover film), whole cloth was manufactured by Toyo Boseki Kabushiki Kaisha, E5002, thickness 125 µm), that had undergone a chemical matte treatment with a barcoater #26, and dried at 100°C for 3 min to form a film having a thickness after drying of 1 µm (IR non-sensitive polymer resin layer). Then, aluminum was evaporated on the surface of the film by vacuum deposition process in a thickness of about 800 Å to form an IR abrasion layer (IR absorbent metal layer), whereby a laminate for IR abrasion (aluminum deposited film) was obtained. The optical density of the IR abrasion layer was 3.5. The optical density (OD) is measured using a black and white transmission densitometer DM-520 (DAINIPPON SCREEN MFG. CO., LTD.).

### Example 2

### Preparation of laminate for IR ablation having anti-blocking layer

### Production of alkyd resin modified with saturated fatty acid

Phthalic anhydride and glycerol were heated to 180°C to give a first stage syrup. Molten stearic acid was added to esterify a free hydroxyl group. Heating was continued from 180°C to 220°C to allow reaction to reach an acid value of 10 (KOH mg/g) to give a stearic acid-modified alkyd resin.

### Production of anti-blocking layer

The obtained stearic acid-modified alkyd resin (400 parts) and a methylated melamine resin (100 parts, Sumitomo Chemical Co., Ltd: SUMIMAL M-100) were dissolved in toluene (25000 parts) and methyl ethyl ketone (24500 parts) to give a coating solution having a solid content of 1 wt%. The coating solution was applied to one surface of a biaxially stretched polyethylene terephthalate film (substrate (cover film), E5002 manufactured by Toyo Boseki Kabushiki Kaisha) having a thickness of 100 µm, a width of 1000 mm and a length of 1200 m by gravure coating to give a roll of film having a coating of an anti-blocking layer. The thickness of the anti-blocking layer after coating and drying was 0.1 µm.

### Production of IR ablation layer

A coating solution having a solid content of 5 wt%, which had been prepared by dissolving polyvinyl alcohol (2000 parts, GOHSENOL KH-20 manufactured by NIPPON SYNTHETIC CHEMICAL INDUSTRY CO., LTD.) and a copolymer of polyethylene glycol arid propylene glycol (1500 parts, SANFLEX SE-270 manufactured by Sanyo Chemical Industries, Ltd.) in pure water (66500 parts), was gravure coated on a surface opposite to the surface having an anti-blocking layer of the above-mentioned film to give a roll of film having a precursor (IR non-sensitive polymer resin layer) of the IR ablation layer. The thickness then of the precursor after drying was 2.0 µm. Any trace of blocking upon unwinding from the roll was not observed. Then, aluminum was deposited on this precursor surface of the IR ablation layer by vacuum deposition methods in a thickness of about 600 Å to form an IR ablation layer (IR absorbent metal layer). This IR ablation layer had an optical density (OD) of 3.0. This optical density (OD) was measured using a black and white transmission densitometer DM-520 (DAINIPPON SCREEN MFG. CO., LTD.). The deposition roll was unwound and the IR ablation layer was evaluated. As a result, the deposition surface was free of unevenness or pattern, had metallic luster, and was firmly adhered to the cover film, whereby a roll of a laminate (aluminum deposited film) for IR ablation, which had an anti-blocking layer and was free of any problem, was obtained.

### Example 3

### Preparation of laminate for IR ablation having release layer

### Production of release layer

Stearic acid-modified alkyd resin (400 parts) obtained in Example 2 and methylated melamine resin (100 parts, Sumitomo Chemical Co., Ltd.: SUMIMAL M-100) were dissolved in toluene (25000 parts) and methyl ethyl ketone (24500 parts) to give a coating solution having a solid content of 1 wt%. The coating solution was applied to one surface of a biaxially stretched polyethylene terephthalate film (substrate (cover film), E5002 manufactured by Toyo Boseki Kabushiki Kaisha) having a thickness of 100 µm, a width of 1000 mm and a length of 1200 m by gravure coating to give a roll of film having a coating of a release layer. The thickness of the release layer after coating and drying was 0.1 µm.

### Production of IR ablation layer

A coating solution having a solid content of 5 wt%, which had been prepared by dissolving polyvinyl alcohol (2000 parts, GOHSENOL KH-20 manufactured by NIPPON SYNTHETIC CHEMICAL INDUSTRY CO., LTD.) and a copolymer of polyethylene glycol and propylene glycol (1500 parts, SANFLEX SE-270 manufactured by Sanyo Chemical Industries, Ltd.) in pure water (66500 parts) was gravure coated on a release layer side of the above-mentioned film having the release layer to give a roll of film having a precursor (IR non-sensitive polymer resin layer) of the IR ablation layer. The thickness then of the precursor after drying was 2.0 µm. Then, aluminum was deposited on this precursor surface of the IR ablation layer by vacuum deposition methods in a thickness of about 600 Å to form an IR ablation layer (IR absorbent metal layer). This IR ablation layer had an optical density (OD) of 3.0. This optical density (OD) was measured using a black and white transmission densitometer DM-520 (DAINIPPON SCREEN MFG. CO., LTD.). The deposition roll was. unwound and the IR ablation layer was evaluated. As a result, the deposition surface was free of unevenness or pattern, had metallic luster, and no abnormal release from the cover film was observed, whereby a roll of a laminate (aluminum deposited film) for IR ablation, which had a release layer and was free of any problem, was obtained.

### Example 4

### Preparation of laminate for IR ablation having anti-blocking layer and release layer

In the same manner as in Example 2 except that a coating solution containing a stearic acid-modified alkyd resin was gravure coated on both surfaces of a biaxially stretched polyethylene terephthalate film (substrate (cover film), E5002 manufactured by Toyo Boseki Kabushiki Kaisha), a cover film having a release layer and an anti-blocking layer was obtained. In the same manner as in Example 3, an IR ablation layer was formed on the obtained cover film to give a laminate for IR ablation (aluminum deposited film) having an anti-blocking layer and a release layer.

### Comparative Example 1

Using the components shown in the following Table 1, a dispersion containing carbon black, polyvinyl alcohol (GOHSENOL GH-23, manufactured by NIPPON SYNTHETIC CHEMICAL INDUSTRY CO., LTD., thermal decomposition starting temperature: 220°C, Limited Oxygen Index: 22.5) and a plasticizer was prepared. This dispersion was applied onto a PET film (thickness 125 µm) with a #26 barcoater and dried at 100°C for 3 min to evaporate water, whereby smooth non-adhesive coating film (coated amount 4.1 g/m² and optical density of actinic radiation area 4.8) was obtained, or a laminate for abrasion, which comprised an IR ablation layer and a PET film.

**Table 1**

| Component | Amount added (g) | Weight without water (%) | Note |
|---|---|---|---|
| 3% aqueous solution of GH-23 | 53.9 | 36.3 | |
| polyethylene glycol #400 | 1.13 | 25.4 | plasticizer |
| EPAN 740 | 0.004 | 0.09 | dispersant (surfactant) |
| carbon black CW1 | 8.5 | 38.2 | 20% aqueous dispersion |
| distilled water | 36.0 | - | |
| carbon black CW1: manufactured by Orient Chemical Industries, Ltd. polyethylene glycol #400: manufactured by Nacalai Tesque, Inc. EPAN 740: manufactured by Dai-ich Kogyo Seiyaku Co., Ltd. | | | |

### Reference Example 1

### Preparation of plate

A PET protective film was peeled off from a photosensitive printing plate (Printight EF95GC, manufactured by Toyo Boseki Kabushiki Kaisha) consisting of a 250 µm thick PET film support (E5002, manufactured by Toyo Boseki Kabushiki Kaisha), a photosensitive resin layer, a polyvinyl alcohol layer and a PET protective film, and polyvinyl alcohol layer thereunder was removed from the photosensitive resin layer using a conventional adhesive tape. The deposit surface of the laminate (aluminum deposited film) for IR ablation prepared in the above-mentioned Example 1 was superimposed on the exposed photosensitive resin layer, and laminated using a heat press machine at 100°C, 100 kg-weight/cm² to give a plate consisting of a PET support, a photosensitive resin layer, an aluminum deposit layer, a polyvinyl alcohol layer and a chemical matte PET protective film (cover film). The total thickness of this plate was 1.05 mm.

### IR ablation

The chemical matte PET protective film (cover film) was peeled off from the above-mentioned plate. At this time, the protective film (cover film) alone was peeled off and the polyvinyl alcohol layer and the aluminum deposition layer remained on the photosensitive resin layer. This photosensitive resin layer was observed with a loupe (10x magnification). As a result, breakage and flaws were not observed in the polyvinyl alcohol layer and the aluminum deposition layer. This plate was wound around a rotary drum of Cyrel Digital Imager Spark (manufactured by BARCO) with the polyvinyl alcohol layer on the upper side and the support PET film on the back side. After vacuuming, an image was formed with diode laser. The laser output of this apparatus used was 4.8 mW, laser resolution was 2540 dpi, and laser spot diameter was 15 µm. The rotary drum rotated at 1500 rpm. After IR ablation, the plate was taken out and observed with a loupe (10x magnification). As a result, aluminum deposition layer was ablated without any problem.

### Practicing plate making

The entire photosensitive printing plate covered with a digital image mask, which had undergone the above-mentioned IR ablation, was exposed to actinic radiation for 3 min and then developed at 25°C for 2 min with a conventional developing unit (TOMIFLEX; Washer manufactured by Tomihiro Sangyo). As a developer, used was tap water. During development, the remaining IR ablation layer (aluminum deposition layer, polyvinyl alcohol layer) and non-irradiated areas of the photosensitive resin layer were removed, leaving the area exposed to actinic radiation. After the development, the plate was dried at 70°C for 10 min and exposed to actinic radiation for 5 min.

The finished relief printing plate was examined with a loupe (10x magnification) All the test patterns of 2 point convex part and concave letters, 30 µm wide fine line, 100 µm diameter isolated dot and 156 lpi, 1% halftone dot were found to have been correctly formed.

### Reference Example 2

### Preparation of plate

In the same manner as in Reference Example 1, a chemical matte PET protective film was released from a photosensitive flexo printing plate (Cosmolight NEO, manufactured by Toyo Boseki Kabushiki Kaisha) consisting of a 100 µm thick PET film support (E5002, manufactured by Toyo Boseki Kabushiki Kaisha), a photosensitive resin layer, a polyvinyl alcohol layer and a chemical matte PET protective film, and a polyvinyl alcohol layer thereunder was removed from the photosensitive resin layer using a conventional adhesive tape. The deposit surface of the laminate for IR ablation having an anti-blocking layer (aluminum deposited film) prepared in the above-mentioned Example 2 was superimposed on the exposed photosensitive resin layer, and laminated using a heat press machine at 100°C, 100 kg-weight/cm² to give a plate consisting of a PET support, a photosensitive resin layer, an aluminum deposit layer, a polyvinyl alcohol layer and a biaxially stretched polyethylene terephthalate protective film (cover film). The total thickness of this plate was 1.90 mm.

### IR ablation

First, for back exposure to make the relief depth a generally employed depth of about 0.8 mm, the PET support side of the above-mentioned flexo plate was exposed to actinic radiation (light source: Philips 10R, illuminance at 365 nm: 7.5 mW/cm²) for 20 sec, and the biaxially stretched PET protective film (cover film) was peeled off. At this time, the protective film (cover film) alone was peeled off and the polyvinyl alcohol layer and the aluminum deposition layer remained on the photosensitive resin layer. This photosensitive resin layer was observed with a loupe (10× magnification). As a result, breakage and flaws were not observed in the polyvinyl alcohol layer and the aluminum deposition layer. This plate was wound around a rotary drum of Cyrel Digital Imager Spark (manufactured by BARCO) with the polyvinyl alcohol layer on the upper side and the support PET film on the back side. After vacuuming, an image was formed with diode laser. The laser output of this apparatus used was 4.8 mW, laser resolution was 2540 dpi, and laser spot diameter was 15 µm. The rotary drum rotated at 1500 rpm. After IR ablation, the plate was taken out and observed with a loupe (10x magnification). As a result, aluminum deposition layer was ablated without any problem.

### Practicing plate making

The entire photosensitive flexo printing plate covered with a digital image mask, which had undergone the above-mentioned IR ablation, was exposed to actinic radiation for 15 min and then developed at 40°C for 6 min with a developing machine (Stuck System) manufactured by Anderson & Vreeland, Inc. As a developer, used was tap water added with a 1% dishwashing detergent Cascade (manufactured by US Procter & Gamble Company). During development, the remaining IR ablation layer (aluminum deposition layer, polyvinyl alcohol layer) and non-irradiated areas of the photosensitive resin layer were removed, leaving the area exposed to actinic radiation. After the development, it was dried at 60°C for 20 min, exposed to actinic radiation for 5 min and finally exposed to a germicidal lamp for 5 min to remove surface adhesiveness. Then, in the same manner as in Reference Example 1, the entire surface of the plate was exposed to actinic radiation and developed to give a finished flexo printing plate, which was examined with a loupe (10x magnification). All the test patterns of 2 point convex part and concave letters, 30 µm wide fine line, 100 µm diameter isolated dot and 156 lpi, 1% halftone dot were found to have been correctly formed.

### Reference Example 3

### Preparation of plate

In the same manner as in Reference Example 1, a photosensitive resin layer of a photosensitive printing plate (Printight EF95GC manufactured by Toyo Boseki Kabushiki Kaisha) was exposed and the deposit surface of the laminate for IR ablation (aluminum deposited film) having a release layer prepared in Example 3 was superimposed on the exposed photosensitive resin layer and laminated using a heat press machine at 80°C, 100 kg-weight/cm², whereby a plate comprising a PET support, a photosensitive resin layer, an aluminum deposition layer and a biaxially stretched polyethylene terephthalate protective film (cover film) was obtained. The total thickness of this plate was 0.98 mm.

In the same manner as in Reference Example 1, images were formed (IR ablation) using a diode laser, and the plate was taken out and observed with a loupe (10x magnification). As a result, no problem was found and ablation of an aluminum deposition layer was confirmed.

Thereafter, in the same manner as in Reference Example 1, the entire surface of the plate was exposed to actinic radiation, developed, and the resulting relief printing plate was checked with a loupe (10x magnification). As a result, all test patterns of 2 point convex part and concave letter, 30 µm wide fine line, 100 µm diameter isolated dot and 156 lpi, 1% halftone were found to have been accurately formed.

### Reference Example 4

In the same manner as in Reference Example 1 except that a laminate for IR ablation (aluminum deposited film) having an anti-blocking layer and a release layer, which was obtained in Example 4, was used, a plate was prepared and a printing plate was obtained. As a result, the test patterns were accurately formed as in Reference Example 1.

### Reference Example 5

In the same manner as in Reference Example 2 except that a laminate for IR ablation (aluminum deposited film) having an anti-blocking layer and a release layer, which was obtained in Example 4, was used, a plate was prepared and a printing plate was obtained. As a result, the test patterns were accurately formed as in Reference Example 2.

### Comparative Reference Example 1

### Preparation of plate

The PET film (cover film) having an IR ablation layer, which was prepared in the above-mentioned Comparative Example 1, and a photosensitive printing plate as used in Reference Example 1 were laminated using a heat press machine at about 100°C, 100 kg-weight/cm² to give a plate comprising a PET support, a photosensitive resin layer, an IR ablation layer and a PET film (cover film).

Then, the PET film, which was a cover film of the obtained plate, was peeled off, and in the same manner as in Reference Example 1, the IR ablation layer was examined upon enlargement with a loupe (10× magnification) before exposure to actinic radiation. As a result, partial breakage and numerous flaws were found.

In the same manner as in Reference Example 1, the plate was developed after exposure to actinic radiation. As a result, the developer was stained with a large amount of carbon black, and the developer could not be used for the production of the next plate. The finished flexo printing plate was examined with a loupe (10× magnification). As a result, small convex parts and defective parts of the relief other than the desired image were found due to the effect of flaws occurred on the aforementioned IR ablation layer, and image reproducibility was poor.

As is clear from the foregoing explanation, by using the laminate for IR ablation of the present invention, conventional facility and method can be used as they are, easy and high-precision formation of a mask is possible, and a printing plate and a relief plate that afford high grade printed images can be obtained. In addition, the developer does not get very dirty during developing and plural sheets can be developed continuously, and the like, and the present invention greatly contributes to industry.

## Claims

1. A laminate for IR ablation comprising at least a substrate and an IR ablation layer, wherein the aforementioned IR ablation layer comprises an IR absorbent metal layer.

2. The laminate for IR ablation of claim 1, wherein the IR absorbent metal layer is a metal deposition layer.

3. The laminate for IR ablation of claim 1, which further comprises an anti-blocking layer on the opposite side of the IR ablation layer of the substrate.

4. The laminate for IR ablation of claim 1, which further comprises a release layer between the substrate and the IR ablation layer.

5. The laminate for IR ablation of claim 3, wherein the anti-blocking layer comprises a thermosetting resin.

6. The laminate for IR ablation of claim 3, wherein the anti-blocking layer comprises an alkyd resin.

7. The laminate for IR ablation of claim 4, wherein the release layer comprises a thermosetting resin.

8. The laminate for IR ablation of claim 4, wherein the release layer comprises an alkyd resin.

9. The laminate for IR ablation of claim 1, which further comprises an IR non-sensitive polymer resin layer between the substrate and the IR absorbent metal layer.

10. The laminate for IR ablation of claim 4, which further comprises an IR non-sensitive polymer resin layer between the release layer and the IR absorbent metal layer.

11. A method for forming a mask on a photosensitive resin layer, which comprises a step of IR ablation of a laminate according to any of claims 1 to 10 which is laminated on said photosensitive resin layer.
